# EUROPÄISCHE PATENTSCHRIFT

(11) **EP 4 348 726 B1**
(45) Veröffentlichungstag und Bekanntmachung des Hinweises auf die Patenterteilung: **02.12.2026**
(21) Anmeldenummer: 22729482.4
(22) Anmeldetag: 13.05.2022
(51) Int. Cl.: H02N 2/04, H10N 30/50

(54) **PIEZOELEKTRISCHES VIELSCHICHTENELEMENT**
PIEZOELECTRIC MULTILAYER ELEMENT
ÉLÉMENT PIÉZO-ÉLECTRIQUE MULTICOUCHE

(30) Priorität: 28.05.2021 DE 102021113843
(43) Veröffentlichungstag der Anmeldung: 10.04.2024
(73) Patentinhaber: TDK Electronics AG, 81671 München (DE)
(72) Erfinder: WALLNÖFER, Wolfgang, 8530 Deutschlandsberg (AT); LÖNNBERG, Jockum, 8530 Deutschlandsberg (AT); BURGER, Johannes, 96166 Kirchlauter (DE)
(74) Vertreter: Epping - Hermann - Fischer
(86) Internationale Anmeldenummer: PCT/EP2022/063009
(87) Internationale Veröffentlichungsnummer: WO 2022/248244

(56) Entgegenhaltungen:
- DE-A1- 102004 002 249
- DE-A1- 19 625 921
- DE-T2- 69 635 870
- JP-A- 2019 213 401

## Beschreibung

Die vorliegende Erfindung betrifft eine Vorrichtung, die ein piezoelektrisches Vielschichtelement und ein mechanisches Verstärkungselement aufweist. Eine derartige Vorrichtung kann beispielsweise als Aktuator zur Erzeugung eines haptisch wahrnehmbaren Signals verwendet werden.

Aus DE 10 2019 120 720 A1, AT 15 914 U1, DE 10 2015 117 262 A1 sowie DE 10 2016 116 763 A1 sind jeweils Aktuatoren mit einem piezoelektrischen Element zwischen zwei Verstärkungselementen bekannt, wobei das Element seine Ausdehnung bei Anlegen einer elektrischen Spannung in eine erste Richtung verändert und die Verstärkungselemente sich infolge der Ausdehnung des Elementes derart verformen, dass ein Teilbereich relativ zu dem Element in eine zweite Richtung, die im Wesentlichen senkrecht zur ersten Richtung ist, bewegt wird. Bei solchen Aktuatoren kann durch eine starke Krafteinwirkung oder Verformung, beispielsweise infolge eines Runterfallens oder Zusammenstoßes, eine Beschädigung des Verstärkungselementes oder des Aktuators oder der Verbindung zwischen Verstärkungselement und Aktuator erfolgen, die zum Ausfall der Aktuatorfunktion führen kann. DE 196 25 921 A1 zeigt einen elektrostriktiven Antrieb mit einem aus paketartig aneinandergereihten Piezoelementen bestehenden Aktuator.

WO2014/096565 A1 zeigt eine Vorrichtung aufweisend ein piezoelektrisches Element und eine metallische Struktur, die ein haptisches Signal erzeugt.

DE 10 2004 002 249 B4 zeigt einen piezoaktiven Aktuator mit einer Bewegungsverstärkung.

US 6,402,499 B1 zeigt eine Vorrichtung, bei der ein piezoelektrisches Element einen Kolben antreibt, wobei ein Federsystem eine oszillierende Bewegung des piezoelektrischen Elements auf den Kolben überträgt.

WO2020/011526 A1 zeigt einen Stylus, der einen piezoelektrischen Aktuator aufweist.

DE 100 17 334 A1 zeigt eine piezoelektrische Betätigungseinrichtung mit einer Anschlagsvorrichtung.

WO2010/094520 A1 betrifft einen piezoelektrischen Generator, insbesondere zum Einsatz in einem Fahrzeugreifenkontrollsystem.

US 8,154,177 B1 zeigt eine Vorrichtung zum "Energy Harvesting".

DE 69 635 870 T2 zeigt ein piezoelektrisches Wandlerelement mit zymbal-förmigen Endkappen.

JP 2019 213401 A zeigt einen Aktuator aufweisend eine Antriebseinheit und einen Umwandlungsmechanismus.

Die Aufgabe der vorliegenden Erfindung ist es nunmehr, eine verbesserte Vorrichtung anzugeben, bei der beispielsweise die Gefahr einer Beschädigung verringert ist.

Es wird eine Vorrichtung gemäß dem Anspruch 1 vorgeschlagen, die ein piezoelektrisches Vielschichtelement mit einer Oberseite aufweist, das dazu ausgestaltet ist, seine Ausdehnung in eine erste Richtung infolge einer angelegten Spannung zu ändern.

Durch die Begrenzung der Wegstrecke, um die der Wirkbereich auf die Oberseite zubewegbar ist, kann eine übermäßige Verformung des mechanischen Verstärkungselementes verhindert werden. Dadurch kann eine Beschädigung der Vorrichtung verhindert werden und ein Ausfallrisiko der Vorrichtung verringert werden. Da der mechanische Anschlag von der Vorrichtung selbst ausgebildet wird, kann auf konstruktive Vorkehrungen in einem mechanischen Umfeld, in dem die Vorrichtung eingebaut wird, verzichtet werden. Dadurch kann der Einbau der Vorrichtung vereinfacht werden und das Ausfallrisiko der Vorrichtung reduziert werden.

Die Wegstrecke, um die der Wirkbereich auf die Oberseite zubewegbar ist, kann dabei jeweils ausgehend von einem Ruhezustand der Vorrichtung bestimmt werden, in dem an die Vorrichtung keine Spannung angelegt ist. Die Wegstrecke, um die der Wirkbereich auf die Oberseite zubewegbar ist, kann beispielsweise auf maximal 5,0 mm beschränkt sein. In anderen Ausführungsformen kann die Wegstrecke auf weniger als 500 µm, vorzugsweise weniger als 100 µm beschränkt sein. Vorzugsweise ist die maximale Wegstrecke auf weniger als 50 % des Abstandes zwischen dem Wirkbereich und der Oberseite in einer Ruhelage der Vorrichtung beschränkt. Dadurch kann in jedem Fall eine Beschädigung der Vorrichtung ausgeschlossen werden.

In einem Ruhezustand der Vorrichtung kann der Wirkbereich von der Oberseite durch eine freie Höhe beabstandet sein. Die freie Höhe kann dabei als maximaler Abstand zwischen einem Punkt des Wirkbereichs und einem Punkt der Oberseite definiert sein, wobei die beiden Punkte einander gegenüberliegen. Der mechanische Anschlag kann derart angeordnet und ausgebildet sein, dass die Wegstrecke, um die der Wirkbereichs aus dem Ruhezustand auf die Oberseite zu bewegbar ist, eine Länge aufweist, die nicht mehr als 50% der freien Höhe beträgt. Ist die Wegstrecke derart beschränkt, können Beschädigungen der Vorrichtungen durch einen Sturz oder anderweitig erzeugte übermäßige Kräfte vermieden werden.

Der mechanische Anschlag kann derart angeordnet und ausgebildet sein, dass die Wegstrecke, um die der Wirkbereichs aus dem Ruhezustand auf die Oberseite zu bewegbar ist, eine Länge aufweist, die mehr als 1% der freien Höhe beträgt. Würde die Wegstrecke, um die der Wirkbereichs aus dem Ruhezustand auf die Oberseite zu bewegbar ist, auf weniger als 1% beschränkt werden, wäre es unter Umständen nicht möglich, zuverlässig ein haptisch wahrnehmbares Signal zu erzeugen, da die Amplitude des Signals zu stark begrenzt wäre.

Vorzugsweise kann der mechanische Anschlag derart angeordnet und ausgebildet sein, dass die Wegstrecke, um die der Wirkbereichs aus dem Ruhezustand auf die Oberseite zu bewegbar ist, eine Länge aufweist, die in einem Bereich zwischen 2% und 40% der freien Höhe liegt. In diesem Bereich ist die Erzeugung gut wahrnehmbarer haptischer Signale gesichert und Beschädigungen werden zuverlässig vermieden.

Die Begrenzung der Wegstrecke kann dadurch erfolgen, dass der mechanische Anschlag an die Oberseite anschlägt und dadurch eine weitere Bewegung des Wirkbereichs auf die Oberseite verhindert.

Der mechanische Anschlag wird durch ein Umformen eines Teilbereichs des Wirkbereichs gebildet. Der Teilbereich kann dabei durch ein Tiefziehen oder ein Stanzen umgeformt sein. Dabei wird der Teilbereich derart umgeformt, dass sein Abstand zu dem piezoelektrischen Vielschichtelement geringer ist als der Abstand von anderen Bereichen des Wirkbereichs, sodass der Teilbereich, wenn sich der Wirkbereich auf das piezoelektrische Vielschichtelement zubewegt, mit dem piezoelektrischen Vielschichtelement zuerst in Kontakt tritt.

Der mechanische Anschlag kann derart angeordnet und ausgebildet sein, dass die Wegstrecke, um die der Wirkbereich auf die Oberseite zubewegbar ist, auf eine Länge begrenzt ist, bei der eine Beschädigung der Vorrichtung unterbunden ist. Durch die Begrenzung der Wegstrecke kann eine irreversible Verformung des mechanischen Verstärkungselementes verhindert werden.

Das piezoelektrische Vielschichtelement kann einen quaderförmigen Grundkörper mit einer rechteckigen Grundfläche aufweisen, wobei das mechanische Verstärkungselement bügelförmig ist. Alternativ kann der Grundkörper eine quadratische Grundfläche aufweisen, wobei das mechanische Verstärkungselement kegelstumpfförmig ist.

Die Vorrichtung kann ein Aktuator sein. Die Vorrichtung kann dabei insbesondere zur Erzeugung eines haptisch wahrnehmbaren Signals eingesetzt werden. Alternativ oder ergänzend kann die Vorrichtung ein Sensor sein, der dazu ausgestaltet ist, einen auf dem Wirkbereich des mechanischen Verstärkungselementes ausgeübten Druck zu messen. Insbesondere kann die Vorrichtung gleichzeitig als Aktuator und Sensor eingesetzt werden.

Im Folgenden werden bevorzugte Ausführungsformen der vorliegenden Erfindung anhand der Figuren beschrieben.
Figur 1 zeigt ein erstes Ausführungsbeispiel der Vorrichtung in einer Seitenansicht.
Figur 2 zeigt ein zweites Ausführungsbeispiel der Vorrichtung in einer Seitenansicht.
Figur 3 zeigt einen Querschnitt durch ein drittes Ausführungsbeispiel der Vorrichtung in perspektivischer Ansicht.

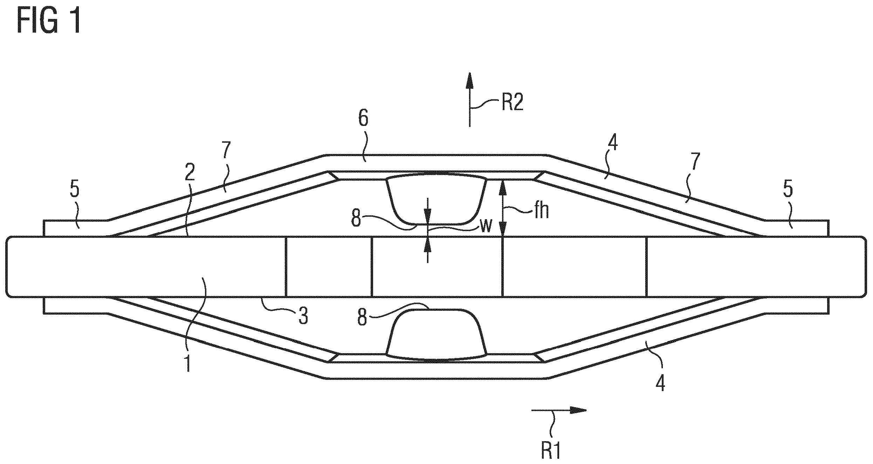

Figur 1 zeigt ein erstes Ausführungsbeispiel einer Vorrichtung, die insbesondere zur Erzeugung eines haptisch wahrnehmbaren Signals eingesetzt werden kann. Alternativ oder ergänzend kann die Vorrichtung als Drucksensor eingesetzt werden.

Die Vorrichtung weist ein piezoelektrisches Vielschichtelement 1 auf. Das piezoelektrische Vielschichtelement 1 weist Innenelektroden und piezoelektrische Schichten auf, die abwechselnd übereinandergestapelt sind. Das piezoelektrische Vielschichtelement 1 ist quaderförmig. Das piezoelektrische Vielschichtelement 1 weist eine Oberseite 2 und eine Unterseite 3 auf, die der Oberseite 2 gegenüberliegt.

Als Höhe wird die Ausdehnung des piezoelektrischen Vielschichtbauelementes 1 zwischen der Oberseite 2 und der Unterseite 3 bezeichnet. Die Höhe des piezoelektrischen Vielschichtelementes 1 kann zwischen 0,3 mm und 20 mm liegen, vorzugsweise zwischen 0,5 mm und 10 mm.

Das piezoelektrische Vielschichtelement 1 weist eine zur Höhe rechteckige Grundfläche auf, die von einer Breite und einer Länge aufgespannt werden. Dabei kann die Länge zwischen 5 mm und 80 mm liegen und die Breite kann zwischen 2 mm und 20 mm liegen, wobei die Länge die längere Kante der rechteckigen Grundfläche bezeichnet. Bei dem in Figur 1 gezeigten Ausführungsbeispiel weist das piezoelektrische Vielschichtelement 1 eine Länge von 12 mm, eine Breite von 4 mm und eine Höhe von 1,75 mm auf.

Als erste Richtung R1 wird im Folgenden eine Längsrichtung des piezoelektrischen Vielschichtelements 1 bezeichnet, d.h. eine Richtung, die entlang der Länge des piezoelektrischen Vielschichtelements verläuft.

Wird an die Innenelektroden des piezoelektrischen Vielschichtelementes eine elektrische Spannung angelegt, verformt sich das piezoelektrische Vielschichtelement 1 infolge des piezoelektrischen Effektes und ändert dabei seine Ausdehnung in die erste Richtung R1.

Die Vorrichtung weist ferner zwei mechanische Verstärkungselemente 4 auf. Ein erstes mechanisches Verstärkungselement 4 ist an der Oberseite 2 des piezoelektrischen Vielschichtelements 1 befestigt. Ein zweites mechanisches Verstärkungselement 4 ist an der Unterseite 2 des piezoelektrischen Vielschichtelements 1 befestigt. Da beide mechanischen Verstärkungselemente 4 baugleich sind, wird im Folgenden das erste mechanische Verstärkungselement 4 beschrieben.

Das erste mechanische Verstärkungselement 4 ist bügelförmig. Das mechanische Verstärkungselement 4 weist dabei zwei einander gegenüberliegende Endbereiche 5 auf, die jeweils an der Oberseite 2 des piezoelektrischen Vielschichtelementes 1 befestigt sind. Beispielsweise können die Endbereiche 5 mit der Oberseite 2 des piezoelektrischen Vielschichtelementes 1 verklebt sein.

Ferner weist das mechanische Verstärkungselement 4 einen Wirkbereich 6 auf. Der Wirkbereich 6 ist relativ zu der Oberseite 2 des piezoelektrischen Vielschichtelementes 1 bewegbar. Liegt an dem piezoelektrischen Vielschichtelement 1 keine elektrische Spannung an und befindet sich dieses dementsprechend in einem Ruhezustand, ist der Wirkbereich 6 des mechanischen Verstärkungselementes 4 von der Oberseite 2 durch eine freie Höhe fh getrennt. Als freie Höhe fh kann dabei der maximale Abstand zwischen einem Punkt der Oberseite 2 und einem Punkt auf der Seite des mechanischen Verstärkungselements 4, die der Oberseite zugewandt ist, bezeichnet werden, wobei eine Verbindungslinie der beiden Punkte senkrecht zu der Oberseite steht. Der Wirkbereich 6 verläuft parallel zu der Oberseite 2 des piezoelektrischen Vielschichtelementes 1.

Ferner weist das bügelförmige mechanische Verstärkungselement 4 zwei Winkelbereiche 7 auf, die die beiden Endbereiche 5 jeweils mit dem Wirkbereich 6 verbinden. Jeder der Winkelbereiche 7 verläuft zu der Oberseite 2 des piezoelektrischen Vielschichtelementes 1 in einem flachen Winkel. Die Verbindungspunkte zwischen den Endbereichen 5 und den Winkelbereichen 7 sowie die Verbindungspunkte zwischen den Winkelbereichen 7 und dem Wirkbereich 6 bilden jeweils Gelenkpunkte, an denen sich das mechanische Verstärkungselement verformen kann, wenn die Ausdehnung des piezoelektrischen Vielschichtelementes 1 in die erste Richtung R1 geändert wird.

Dehnt sich das piezoelektrische Vielschichtelement 1 in die erste Richtung R1 aus, werden die beiden Endbereiche 5 des ersten mechanischen Verstärkungselementes 4 auseinandergezogen. Diese Bewegung der Endbereiche 5 wird über die Winkelbereich 7 auf den Wirkbereich 6 übertragen, der sich infolgedessen auf die Oberseite 2 des piezoelektrischen Vielschichtelementes 1 zu bewegt. Wird umgekehrt die Ausdehnung des piezoelektrischen Vielschichtelementes 1 in die erste Richtung R1 verringert, werden die beiden Endbereiche 5 aufeinander zubewegt, wodurch der Wirkbereich 6 von der Oberseite 2 des piezoelektrischen Vielschichtelementes 1 wegbewegt wird.

Das mechanische Verstärkungselement 4 ermöglicht es somit, eine Änderung der Ausdehnung des piezoelektrischen Vielschichtelementes 1 in die erste Richtung R1 in eine Bewegung des Wirkbereichs 6 in eine zweite Richtung R2 umzuwandeln, wobei die zweite Richtung senkrecht zu der ersten Richtung ist. Dabei kann die Amplitude der Bewegung in die zweite Richtung R2 deutlich größer sein als die Änderung der Ausdehnung des piezoelektrischen Vielschichtelementes in die erste Richtung R1.

Wird nunmehr eine Wechselspannung an die Innenelektroden des piezoelektrischen Vielschichtelementes 1 angelegt, wird der Wirkbereich 6 in eine Vibration versetzt, wobei er in die zweite Richtung R2 schwingt. Durch diese Vibration kann ein haptisch wahrnehmbares Signal erzeugt werden.

Analog kann die Vorrichtung auch als Sensor eingesetzt werden, wobei ein auf den Wirkbereich 6 des mechanischen Verstärkungselementes ausgeübter Druck zur Erzeugung einer Spannung in dem piezoelektrischen Vielschichtelement 1 führt.

An dem Wirkbereich 6 des mechanischen Verstärkungselementes 4 ist ein mechanischer Anschlag 8 ausgebildet. Wird der Wirkbereich 6 auf die Oberseite 2 des piezoelektrischen Vielschichtelementes 1 zubewegt, wird die Wegstrecke w, um die diese Bewegung möglich ist, durch den mechanischen Anschlag begrenzt. Der mechanische Anschlag 8 schlägt dann an die Oberseite 2 des piezoelektrischen Vielschichtelementes 1 an und verhindert eine weitere Bewegung des Wirkbereichs 6 auf das piezoelektrische Vielschichtelement 1 zu.

In dem in Figur 1 gezeigten Ausführungsbeispiel ist der mechanische Anschlag 8 durch eine Umformung eines Teils des Wirkbereichs 6 des bügelförmigen Verstärkungselementes gebildet. Die Umformung wird dabei durch ein Tiefziehen des Teils des Wirkbereichs gebildet. Der umgeformte Teil des Wirkbereichs 6 ragt in Richtung der Oberseite 2 von dem übrigen Wirkbereich vor. Wird nun der Wirkbereich 6 auf die Oberseite 2 zubewegt, kommt zuerst der mechanische Anschlag 8 mit der Oberseite 2 in Kontakt und verhindert eine weitere Bewegung des Wirkbereichs 6 auf die Oberseite 2 zu. Dadurch wird auch eine weitere Verformung des mechanischen Verstärkungselementes 4 verhindert.

Dadurch verhindert der mechanische Anschlag insbesondere, dass das mechanische Verstärkungselement 4 infolge einer übermäßigen Krafteinwirkung irreversibel verformt wird. Dadurch werden Beschädigungen des mechanischen Verstärkungselementes 4 verhindert. Zu einer solchen übermäßigen Krafteinwirkung kann es insbesondere durch einen Fall oder einen Zusammenstoß der Vorrichtung kommen.

Der mechanische Anschlag kann derart ausgestaltet sein, dass der Wirkbereich um eine maximale Wegstrecke zwischen 50 µm und 5 mm auf die Oberseite zubewegbar ist. Dementsprechend kann im Ruhezustand der Abstand zwischen dem mechanischen Anschlag und der Oberseite zwischen 50 µm und 5 mm liegen.

Die Wegstrecke w, um die der Wirkbereich 6 maximal auf die Oberseite 2 zu bewegbar ist, kann weniger als 50 % der freien Höhe fh betragen. Bei einem mechanischen Verstärkungselement 4, bei dem die maximale Wegstrecke w auf weniger als 50 % der freien Höhe fh beschränkt ist, können Beschädigungen durch übermäßige Verformungen des mechanischen Verstärkungselements 4 ausgeschlossen werden.

Wird der mechanische Anschlag 8 durch eine Umformung eines Teils des Wirkbereichs 6 geformt, kann die Umformung mit einer Toleranz von weniger als 15 % Genauigkeit konstruiert werden, vorzugsweise mit einer Toleranz von weniger als 10 %.

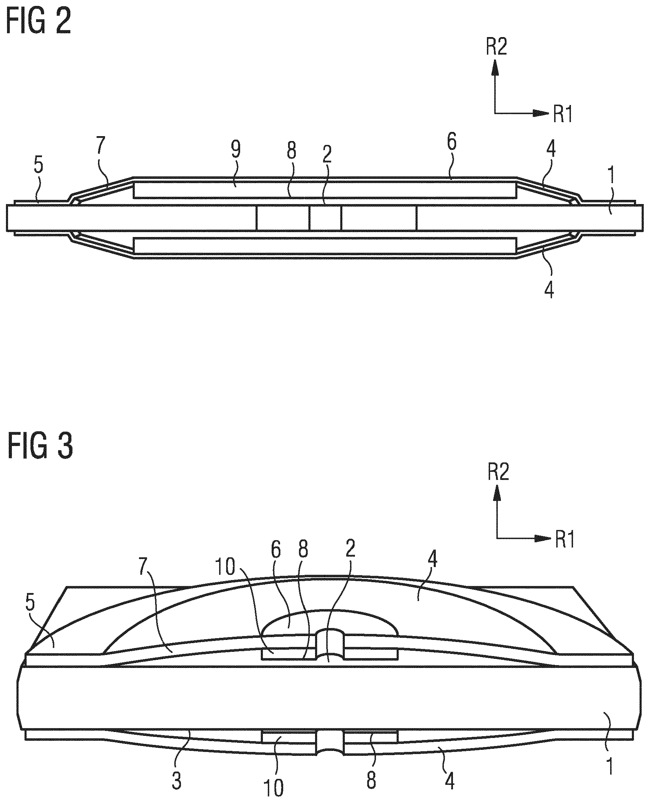

Figur 2 zeigt ein zweites Ausführungsbeispiel der Vorrichtung. In dem zweiten Ausführungsbeispiel wird der mechanische Anschlag 8 durch eine Stützplatte 9 gebildet, die mit dem Wirkbereich 6 verschraubt ist. Dabei ist die Stützplatte 9 an einer Seite des Wirkbereichs 6 ausgebildet, die auf die Oberseite 2 des piezoelektrischen Vielschichtelementes zuweist. Die Stützplatte 9 bildet den mechanischen Anschlag 8, der zuerst mit der Oberseite des piezoelektrischen Vielschichtelementes in Kontakt kommt und die maximale Wegstrecke w beschränkt, um die der Wirkbereich 6 auf die Oberseite 2 zubewegbar ist. Das in dem zweiten Ausführungsbeispiel gezeigte piezoelektrische Vielschichtelement 1 weist eine Länge von 60 mm, eine Breite von 5 mm und eine Höhe von 7 mm auf. Der Wirkbereich 6 kann aus seiner Ruhelage um eine maximale Wegstrecke von 2 mm auf die Oberseite 2 des piezoelektrischen Vielschichtelementes 1 zubewegt werden.

Figur 3 zeigt ein drittes Ausführungsbeispiel der Vorrichtung. Bei dem in Figur 3 gezeigten Ausführungsbeispiel weist das piezoelektrische Vielschichtelement 1 eine quadratische Grundfläche auf. Figur 3 zeigt die Vorrichtung in einem Querschnitt. Das piezoelektrische Vielschichtelement 1 weist eine Länge und eine Breite von jeweils 13 mm und eine Höhe von 1,8 mm auf.

Die mechanischen Verstärkungselemente 4 sind kegelstumpfförmig. Die kegelstumpfförmigen Verstärkungselemente 4 weisen Endbereiche 5 auf, die auf der Oberseite 2 bzw. der Unterseite 3 des piezoelektrischen Vielschichtelements 1 befestigt sind, auf. Die kegelstumpfförmigen Verstärkungselemente 4 weisen je einen Wirkbereich 6 auf, der parallel zu der Oberseite bzw. der Unterseite des piezoelektrischen Vielschichtelements verläuft und von diesen im Ruhezustand durch eine freie Höhe fh beabstandet ist. Der Endbereich 5 und der Wirkbereich 6 sind über einen Winkelbereich 7 verbunden.

Die mechanischen Anschläge 8 an den Wirkbereichen 6 der mechanischen Verstärkungselemente 4 sind durch Stützringe 10 gebildet, die an den Seiten der mechanischen Verstärkungselemente 4 angeklebt sind, die zur Oberseite 2 beziehungsweise zur Unterseite 3 weisen. Im Ruhezustand der Vorrichtung sind die mechanischen Anschläge 8 von der Oberseite 2 beziehungsweise von der Unterseite 3 um eine Länge beabstandet, die kleiner ist als die freie Höhe fh. Der Wirkbereich 6 des mechanischen Verstärkungselements 4, das an der Oberseite 2 befestigt ist, kann aus dem Ruhezustand um maximal eine Wegstrecke w auf die Oberseite zubewegt werden, die gleich der Länge ist, um die der mechanischen Anschlag 8 von der Oberseite 2 im Ruhezustand beabstandet ist. Der mechanische Anschlag 8 begrenzt die maximale Weglänge w, um die die Wirkbereiche 6 auf die Ober- beziehungsweise Unterseite aus der Ruhelage zubewegt werden können, in dem dritten Ausführungsbeispiel auf 0,2 mm.

In weiteren nicht gezeigten Ausführungsbeispielen kann der mechanische Anschlag 8 an dem piezoelektrischen Vielschichtelement 1 ausgebildet sein. Dabei kann der Anschlag 8 an der Oberseite 2 des piezoelektrischen Vielschichtelementes 1, die zu dem Wirkbereich weist, angeordnet sein und beispielsweise durch ein auf die Oberfläche 2 aufgeklebtes Element gebildet werden.

### Bezugszeichen

- 1: Vielschichtelement
- 2: Oberseite
- 3: Unterseite
- 4: mechanisches Verstärkungselement
- 5: Endbereich
- 6: Wirkbereich
- 7: Winkelbereich
- 8: Anschlag
- 9: Stützplatte
- 10: Stützring
- fh: freie Höhe
- R1: erste Richtung
- R2: zweite Richtung
- w: Wegstrecke

## Patentansprüche

1. Vorrichtung aufweisend,
ein piezoelektrisches Vielschichtelement (1) mit einer Oberseite (2), das dazu ausgestaltet ist, seine Ausdehnung in eine erste Richtung (R1) in Folge einer angelegten Spannung zu ändern, und
ein mechanisches Verstärkungselement (4), das einen Endbereich, der auf der Oberseite (2) des piezoelektrischen Vielschichtelements (1) befestigt ist, und einen Wirkbereich (6), der relativ zu dem piezoelektrischen Vielschichtelement (1) bewegbar ist, aufweist,
wobei das mechanische Verstärkungselement (4) derart ausgestaltet ist, dass der Wirkbereich (6) in eine zur ersten Richtung (R1) senkrechte zweite Richtung (R2) bewegt wird, wenn sich die Ausdehnung des piezoelektrischen Vielschichtelements (1) ändert, wobei die zweite Richtung (R2) parallel zur Flächennormalen der Oberseite (2) ist, und
wobei die Vorrichtung einen mechanischen Anschlag (8) aufweist, der eine Wegstrecke (w) begrenzt, um die der Wirkbereichs (6) auf die Oberseite (2) zu bewegbar ist,
wobei die Vorrichtung **dadurch gekennzeichnet ist, dass** der mechanische Anschlag (8) ein umgeformter Teil des Wirkbereichs (6) ist, der in Richtung der Oberseite (2) von dem übrigen Wirkbereich vorragt.

2. Vorrichtung gemäß Anspruch 1, wobei die Vorrichtung derart ausgestaltet ist,
dass die Begrenzung der Wegstrecke (w) dadurch erfolgt,
dass der mechanische Anschlag (8) an die Oberseite (2) anschlägt und dadurch ein weitere Bewegung des Wirkbereichs (6) auf die Oberseite (2) zu verhindert, oder
dass die Begrenzung der Wegstrecke (w) dadurch erfolgt,
dass der mechanische Anschlag (8) an das piezoelektrische Vielschichtelement (1) anschlägt und dadurch ein weitere Bewegung des Wirkbereichs (6) auf die Oberseite (2) zu verhindert.

3. Vorrichtung gemäß einem der Ansprüche 1 bis 2,
wobei der mechanische Anschlag (8) an dem Wirkbereich (6) ausgebildet ist.

4. Vorrichtung gemäß einem der Ansprüche 1 bis 3,
wobei das piezoelektrische Vielschichtelement (1) einen quaderförmigen Grundkörper mit einer rechteckigen Grundfläche aufweist, und
wobei das mechanische Verstärkungselement (4) bügelförmig ist.

5. Vorrichtung gemäß einem der Ansprüche 1 bis 4,
wobei das piezoelektrische Vielschichtelement (1) einen quaderförmigen Grundkörper mit einer quadratischen Grundfläche aufweist, und
wobei das mechanische Verstärkungselement (4) kegelstumpfförmig ist.

6. Vorrichtung gemäß einem der Ansprüche 1 bis 5,
wobei die Vorrichtung ein Aktuator ist.

7. Vorrichtung gemäß einem der Ansprüche 1 bis 6,
wobei die Vorrichtung ein Sensor ist, der dazu ausgestaltet ist, einen auf den Wirkbereich (6) des mechanischen Verstärkungselements (4) ausgeübten Druck zu messen.

## Claims

1. A device comprising:
a piezoelectric multilayer element (1) having a top surface (2) and being configured to change its extension in a first direction (R1) in response to an applied voltage;
a mechanical amplifying element (4) comprising an end portion fixed to the top surface (2) of the piezoelectric multilayer element (1) and an active portion (6) movable relative to the piezoelectric multilayer element (1),
wherein the mechanical amplifying element (4) is configured such that the active portion (6) is movable in a second direction (R2) perpendicular to the first direction (R1) when an extension of the piezoelectric multilayer element (1) changes, the second direction (R2) being parallel to a surface normal of the top surface (2); and
wherein the device comprises a mechanical stop (8) limiting a distance (w) by which the active portion (6) is movable towards the top surface (2),
wherein the device is **characterized in that** the mechanical stop (8) is a shaped portion of the active portion (6) that protrudes toward the top surface (2) from the remainder of the active portion (6).

2. The device according to claim 1, wherein the device is configured such that
the limitation of the distance (2) is affected by the mechanical stop (8) striking against the top surface (2) thereby preventing further movement of the active portion (6) towards the top surface (2), or such that
the limitation of the distance (w) is affected by the mechanical stop (8) striking the piezoelectric multilayer element (1) thereby preventing further movement of the active portion (6) towards the top surface (2).

3. The device according to any of claims 1 to 2, wherein the mechanical stop (8) is formed at the active portion (6).

4. The device according to any of claims 1 to 3,
wherein the piezoelectric multilayer element (1) comprises a cuboid base body with a rectangular base surface, and
wherein the mechanical amplifying element (4) is bow-shaped.

5. The device according to any of claims 1 to 4,
wherein the piezoelectric multilayer element (1) comprises a cuboid base body with a square base surface, and
wherein the mechanical amplifying element (4) is frustoconical.

6. The device according to any of claims 1 to 5, wherein the device is an actuator.

7. The device according to any of claims 1 to 6, wherein the device is a sensor configured to measure a pressure exerted on the active portion (6) of the mechanical amplification element (4).

## Revendications

1. Dispositif possédant,
un élément multicouche piézoélectrique (1) comportant un côté supérieur (2), qui est configuré pour modifier son extension dans une première direction (R1) en conséquence d'une tension appliquée, et
un élément de renfort mécanique (4), qui possède une zone d'extrémité, laquelle est fixée sur le côté supérieur (2) de l'élément multicouche piézoélectrique (1), et une zone active (6), qui est mobile par rapport à l'élément multicouche piézoélectrique (1),
l'élément de renfort mécanique (4) étant configuré de telle sorte que la zone active (6) est déplacée dans une deuxième direction (R2) perpendiculaire à la première direction (R1) lorsque l'extension de l'élément multicouche piézoélectrique (1) change, la deuxième direction (R2) étant parallèle à la normale à la surface du côté supérieur (2), et
le dispositif possédant une butée mécanique (8), qui limite une course (w) possible pour déplacer la zone active (6) vers le côté supérieur (2),
le dispositif étant **caractérisé en ce que** la butée mécanique (8) est une partie façonnée de la zone active (6), qui fait saillie de la zone active restante en direction du côté supérieur (2).

2. Dispositif selon la revendication 1, le dispositif étant configuré de telle sorte que la limitation de la course (w) est effectuée en ce que la butée mécanique (8) vient frapper le côté supérieur (2) et empêche ainsi un déplacement supplémentaire de la zone active (6) vers le côté supérieur (2), ou
en ce que la limitation de la course (w) est effectuée en ce que la butée mécanique (8) vient frapper l'élément multicouche piézoélectrique (1) et empêche ainsi un déplacement supplémentaire de la zone active (6) vers le côté supérieur (2).

3. Dispositif selon l'une des revendications 1 à 2,
la butée mécanique (8) étant configurée au niveau de la zone active (6).

4. Dispositif selon l'une des revendications 1 à 3,
l'élément multicouche piézoélectrique (1) possédant un corps de base parallélépipédique ayant une surface de base rectangulaire, et
l'élément de renfort mécanique (4) étant en forme d'étrier.

5. Dispositif selon l'une des revendications 1 à 4,
l'élément multicouche piézoélectrique (1) possède un corps de base parallélépipédique ayant une surface de base carrée, et
l'élément de renfort mécanique (4) étant de forme tronconique.

6. Dispositif selon l'une des revendications 1 à 5,
le dispositif étant un actionneur.

7. Dispositif selon l'une des revendications 1 à 6,
le dispositif étant un capteur, qui est configuré pour mesurer une pression exercée sur la zone active (6) de l'élément de renfort mécanique (4).
